# EUROPEAN PATENT SPECIFICATION

(11) **EP 0 949 668 B1**
(45) Date of publication and mention of the grant of the patent: **18.07.2007**
(21) Application number: 97909671.6
(22) Date of filing: 29.10.1997
(51) Int. Cl.: H01L 21/48

(54) **METHOD FOR FORMING BUMP AND SEMICONDUCTOR DEVICE**
VERFAHREN ZUR HERSTELLUNG VON HÖCKER UND HALBLEITERANORDNUNG
PROCEDE DE FORMATION DE BOSSES ET DISPOSITIF A SEMI-CONDUCTEUR

(30) Priority: 06.11.1996 JP 31006096; 20.02.1997 JP 5237397
(43) Date of publication of application: 13.10.1999
(73) Proprietor: Niigata Seimitsu Co., Ltd., Jouetsu-shi, Niigata 943-0834 (JP)
(72) Inventor: OKAMOTO, Akira, Ageo-shi, Saitama 362 (JP)
(74) Representative: Murgatroyd, Susan Elizabeth
(86) International application number: PCT/JP1997/003925
(87) International publication number: WO 1998/020541

(56) References cited:
- JP-A- 3 074 852
- JP-A- 6 188 290
- US-A- 4 568 012
- PATENT ABSTRACTS OF JAPAN vol. 014, no. 414 (E-0975), 7 September 1990 (1990-09-07) & JP 02 159094 A (ROHM CO LTD), 19 June 1990 (1990-06-19)
- PATENT ABSTRACTS OF JAPAN vol. 1995, no. 11, 26 December 1995 (1995-12-26) & JP 07 201869 A (MATSUSHITA ELECTRIC IND CO LTD), 4 August 1995 (1995-08-04)
- PATENT ABSTRACTS OF JAPAN vol. 1996, no. 11, 29 November 1996 (1996-11-29) & JP 08 181142 A (FUJITSU LTD), 12 July 1996 (1996-07-12)
- PATENT ABSTRACTS OF JAPAN vol. 008, no. 155 (E-256), 19 July 1984 (1984-07-19) & JP 59 058843 A (SHARP KK), 4 April 1984 (1984-04-04)

## Description

The present invention relates to a method of making bumps for use in connecting 2 substrates (for example a printed circuit board and a semiconductor chip) having pads formed thereon in a case of mounting by BGA (ball grid array) or flip chip technique and a semiconductor device made by using the bumps.

One of the technologies for mounting semiconductor chips on a printed circuit board is a BGA (ball grid array) technology in which pads are formed on both of the semiconductor chips and the printed circuit board to be jointed together by way of solder or gold balls. The use of such bumps enables to mount the semiconductor chips on the printed circuit board in higher density than conventional mounting by the use of semiconductor chips having pin-type terminals or by a COB (chip on board) mounting using bonding wires.

On the other hand, the flip chip mounting for directly mounting bare semiconductor chips on a printed circuit board without packaging is gaining popularity in recent years. In the flip chip mounting, pads on the bare chip are also jointed to pads on a printed circuit board by way of bumps.

Known methods of forming bumps for the BGA mounting or the flip chip mounting are a normal bump, a decalcomania transferring bump, ball bump and mesa bump. The normal bump is formed by covering with resist the upper surface of a semiconductor wafer where bumps are not formed and then forming bumps by plating before removing the resist.The decalcomania transferring precess is decalcomania transferring bumps at ends of inner leads and the bumps and aluminium electrodes of a semiconductor chip are aligned before being heated and compressed. The ball bump process is to use a wire bonding machine to attach a bump on each pad. Finally, the mesa bump process is integrally forming bumps on ends of inner leads.

Among these 4 bump forming processes, the decalcomania transferring and mesa bump processes require inner leads which are not suitable for BGA or flip chip mounting. Also, the ball bump process requires to attach bumps on the pads sequentially. This process is time consuming if the number of bumps increases. On the other hand, bumps are formed by plating process in the normal bump process and tend to vary in size and shape.

Patent Abstracts of Japan, vol. 1995, No. 11, 26 December 1995 and JP 07 201869A (Matsushita Electric Ind. Co. Ltd.), 4 August 1995, disclose a method for forming bumps, wherein cream solder is applied to the electrodes on an upper surface of a board by screen printing. The board is then turned over so that the cream solder faces downward, and the board is heated to melt the cream solder, which forms bumps by gravity. The cream solder bumps are then cooled to harden them.

JP-A-02 159 094 discloses a method for forming solder bumps, wherein a substrate with pads is dipped into a solder while the substrate surface with the pads face downwardly.

In the light of the above disadvantages of conventional bump forming processes, the object of the present invention is to provide a method of forming bumps of desired size and shape without requiring complex steps and also to provide a semiconductor device using such bumps.

Accordingly, the present invention consists in a method of forming bumps of electrically conductive material on pads formed on one surface of a first substrate, said bumps being intended for interconnecting with corresponding pads formed on a second substrate by placing the bumps on the corresponding pads and heating to melt the bumps, said method comprising the steps as defined in appended claim 1.

Now, the present invention will be described in detail by reference to the accompanying drawings, wherein:
FIG. 1 illustrates steps of forming the bumps and steps of fabricating a semiconductor device according to the present invention;
FIG. 2 is a detailed illustration of the step in FIG.1(c); and
FIG. 3 is an example of a 2 layered bump.

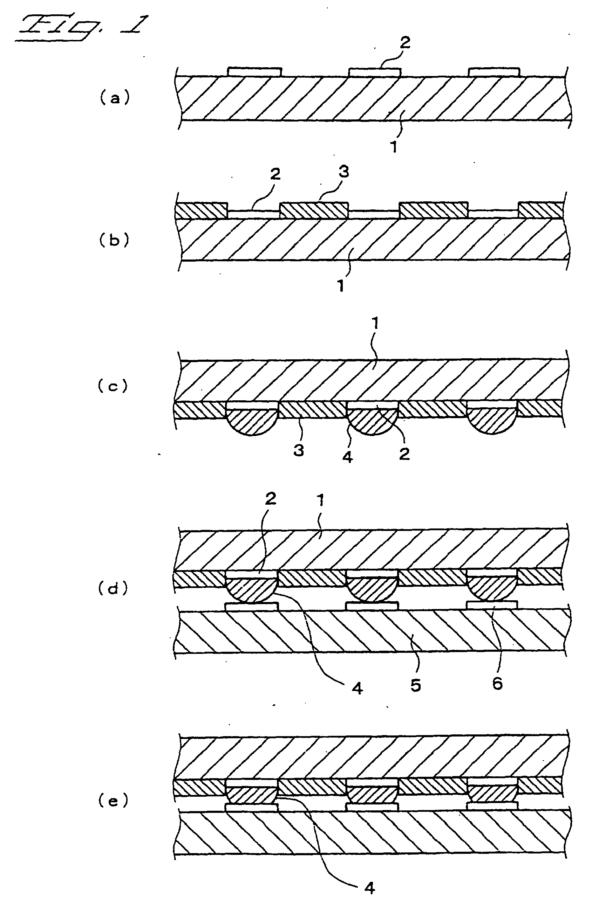

FIG. 1 illustrates the method of forming bumps and steps of fabricating the semiconductor device according to the present invention. FIG.1 shows an example of mounting packaged semiconductor chip on a printed circuit board by the BGA technology. More specifically, it is to joint pads on a package of a semiconductor device and pads on a printed circuit board by way of bumps. The above mentioned printed circuit board and the packaged semiconductor chip correspond to a first and a second substrate, respectively.

Now, as illustrated in FIG. 1(a), pads 2 are formed on a printed circuit board 1 at the same spacing as pads on a semiconductor chip. Then, as shown in FIG. 1(b), the upper surface of the printed circuit board 1 is covered with a resist 3 over the entire area except pad forming areas. Subsequently, the printed circuit board 1 is oriented so that the surface covered by the resist 3 faces downwardly and molten solder is sprayed upwardly onto the printed circuit board 1 to form bumps 4 at the pad forming areas as shown in FIG. 1(c).

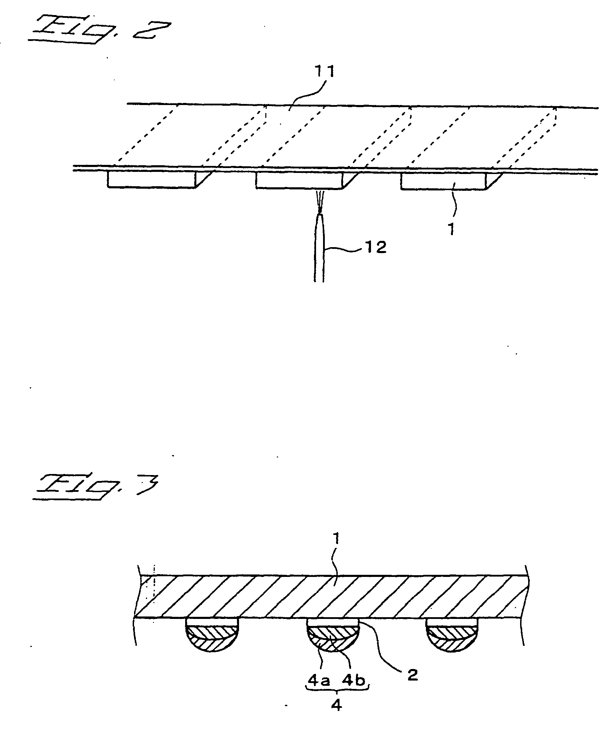

FIG.2 is a detailed illustration of the step in FIG.1(c). As shown in FIG.2. the printed circuit board 1 is placed on the bottom of a conveyor 11 with the pad formed surface of the printed circuit board 1 facing downwardly.Disposed below the conveyor 11 is a nozzle 12 for spraying molten solder. When the conveyor 11 starts to move,the molten solder is sprayed onto the printed circuit board 1 passing above the nozzle 12. The solder will not attach the areas on the printed circuit board 1 covered with the resist 3 but will attach onto the pad formed areas to form a solder layer. Gravity will exert on the solder layer to make it in a semispherical shape, thereby forming each bump 4. Since a constant amount of solder is supplied from the nozzle 12, bumps 4 of substantially constant size will be formed.

After removing the resist 3 from the printed circuit board1 having the bumps 4 formed thereon, it travels through a high temperature oven after alignment with pads 6 on a semiconductor chip 5 as shown in FIG.1(d). As a result, the bumps 4 will be molten to joint the semiconductor chip 5 to the printed circuit board 1 by way of the bumps 4 as shown in FIG. 1(e).

As apparent from the above description, since the solder layer is formed at the pad formed areas by spraying the molten solder onto the pad formed surface of the printed circuit board 1 facing downwardly, gravity exerts on the solder layer to form the ideal semispherical bumps 4 by simple steps and without using special machines, etc.

Also, since all areas of the printed circuit board 1 except the bump forming areas are covered with the resist 3, no solder will attach to any undesired area. Advantageously, a constant amount of the molten solder is sprayed from the nozzle 12 onto the printed circuit baord 1 while it is moving at a constant speed, thereby minimizing any change in size and shape of the bumps 4. Also, manufacturing efficiency is improved by placing a plurality of the printed circuit boards 1 on the conveyor 11 at a constant space to form uniform bumps 4 on the printed circuit boards 1 in a short time.

It is to be noted, however, that the material to be sprayed from the nozzle 12 should not be limited to the above mentioned molten solder but could be various other materials (such as gold) that are adhesive and electrically conductive. It is also possible to spray 2 or more different materials to form the above mentioned bumps 4. Shown in FIG. 3 is an example of a 2-layer-structure of the bumps 4 comprising an upper low melting point solder layer 4a and a lower high melting point solder layer 4b. Such construction is effective to improve adhesiveness of the bumps 4 as compared with conventional single layer bumps 4 because electrical contact with the semiconductor chip 5 is established at the time when the upper solder layer 4a is molten. In case of multi-layer construction of the bumps 4, different materials may be sprayed from a single nozzle 12 or 2 or more nozzles 12 may be used. In case of wider area of the printed circuit board 1, a plurality of nozzles 12 may be placed in a line for simultaneously spraying equal amount of molten solder from each nozzle 12.

In the embodiment as described hereinbefore, the bumps 4 are formed on the printed circuit board 1. However, it is to be noted that the bumps 4 may be formed on the semiconductor chip 5.

Although the embodiment is described about the method of forming bumps for mounting by the BGA technology, this embodiment can be applied for making bumps 4 for flip chip mounting wherein bare chips scribed from a semiconductor wafer are to be mounted on the printed circuit board 1. However, since flip chip mounting requires bumps 4 smaller size than those for the BGA mounting, it is necessary to modify the amount of material sprayed from the nozzle 12.

The material for the pads to be formed on bare chips is generally aluminum, polysilicon, etc. However, since these materials are not easily solderable, it is necessary to have an intermediate metal layer on the surface prior to spraying the molten solder. The intermediate metal layer is prepared in consideration of adhesiveness, mutual diffusion, and solderability. A preferable intermediate metal layer is, for example, a copper or gold layer formed by plating or vapor deposition technique. Alternatively, it may be Cr-Cu-Au, TiW-Cu, Ti-Cu-Ni, Al/Ni-Ni-Cu, etc. Such surface layer is also effective for forming bumps 4 on a printed circuit board and the like formed with pads that are not easily solderable.

In case of flip chip mounting, bumps 4 are formed on a semiconductor wafer prior to scribing and the semiconductor wafer maybe scribed into discrete chips after forming the bumps.

### Industrial Applicability

As described above, according to the present invention, the bumps are formed on a first substrate by spraying electrically conductive.material upwardly onto the surface covered with a resist. Gravity is utilized for forming ideal semispherical bumps. By spraying the electrically conductive material while moving the first substrate by a conveyor the electrically conductive material can be sprayed uniformly on the first substrate, thereby minimizing any variation in size and shape of the bumps.

Also, by spraying 2 or more electrically conductive materials, it is possible to form multi-layer bumps very easily. It is therefore easy to form bumps comprising an upper layer of relatively lower melting point than a lower layer, thereby improving solderability.

## Claims

1. A method of forming bumps (4) of electrically conductive material on pads (2) formed on one surface of a first substrate (1), said bumps (4) being intended for interconnecting with corresponding pads (6) formed on a second substrate (5) by placing the bumps (4) on the corresponding pads (6) and heating to melt the bumps (4), said method comprising the steps of:
a) orienting the first substrate (1) such that the one surface is facing downwardly;
b) depositing molten electrically conductive material of controlled amount upwardly onto the one surface of the first substrate (1) which faces downwardly to form substantially semispherical bumps (4) on the pads (2), **characterized in that**
prior to step a) a step of
c) covering the one surface of the first substrate (1) with resist (3) except on the areas of the pads (2) is carried out, and
the step b) is realised by spraying said molten electrically conductive material upwardly.

2. A method according to claim 1, wherein the molten electrically conductive material is sprayed while the first substrate (1) is being conveyed.

3. A method according to claim 1 or 2, wherein the amount of spraying the molten electrically conductive material is adjusted to form the bumps (4) of a desired size.

4. A method according to claim 1, 2 or 3, wherein two or more different molten electrically conductive materials are sprayed so that each bump (4) consists of two or morse layers of different electrically conductive materials.

5. A method according to claim 4, wherein said two or more different molten electrically conductive materials form an upper layer (4a) of each bump (4) on the pads, the upper layer is of an electrically conductive material having lower melting point than that of a lower layer (4b) of each bump (4) on said upper layer.

6. A method according to any preceding claim, wherein either one of the first and second substrates is a printed circuit board while the other substrate is a semiconductor chip (5).

7. A method according to claim 6, wherein the semiconductor chip (5) is a bare chip scribed from a semiconductor wafer.

8. A method according to claim 7, wherein the bumps (4) are formed over the entire surface of the semiconductor wafer before being scribed.

## Patentansprüche

1. Verfahren zur Bildung von Höckern (4) aus elektrisch leitendem Material auf Polstern (2), die auf einer Oberfläche eines ersten Substrats (1) ausgebildet sind, wobei die Höcker (4) zur Verbindung mit entsprechenden Polstern (6), die auf einem zweiten Substrat (5) ausgebildet sind, vorgesehen sind, indem man die Höcker (4) auf den entsprechenden Polstern (6) platziert und erwärmt, um die Höcker (4) zu schmelzen, wobei das Verfahren die folgenden Stufen umfasst:
a) Orientieren des ersten Substrats (1) in der Weise, dass die eine Oberfläche nach unten gerichtet ist;
b) Abscheiden von geschmolzenem, elektrisch leitendem Material in einer kontrollierten Menge in Richtung nach oben auf die eine Oberfläche des ersten Substrats (1), die nach unten gerichtet ist, zur Bildung von im wesentlichen halbkugelförmigen Höckern (4) auf den Polstern (2),
**dadurch gekennzeichnet, dass** vor der Stufe a) eine Stufe c) durchgeführt wird, bei der die eine Oberfläche des ersten Substrats (1) mit Resist (3) bedeckt wird, ausgenommen die Bereiche der Polster (2), und die Stufe b) ausgeführt wird, indem man das geschmolzene, elektrisch leitende Material in Richtung nach oben sprüht.

2. Verfahren nach Anspruch 1, wobei das geschmolzene, elektrisch leitende Material versprüht wird, während das erste Substrat (1) befördert wird.

3. Verfahren nach Anspruch 1 oder 2, wobei die Sprühmenge des geschmolzenen, elektrisch leitenden Materials so eingestellt wird, dass Höcker (4) mit einer angestrebten Größe gebildet werden.

4. Verfahren nach Anspruch 1, 2 oder 3, wobei zwei oder mehr verschiedene, geschmolzene, elektrisch leitende Materialien so aufgesprüht werden, dass die einzelnen Höcker (4) aus zwei oder mehr Schichten von verschiedenen, elektrisch leitenden Materialien bestehen.

5. Verfahren nach Anspruch 4, wobei die zwei oder mehr verschiedenen, geschmolzenen, elektrisch leitenden Materialien eine obere Schicht (4a) eines jeden Höckers (4) auf den Polstern bilden, wobei die obere Schicht aus einem elektrisch leitenden Material besteht, das einen niedrigeren Schmelzpunkt als eine untere Schicht (4b) eines jeden Höckers (4) auf der oberen Schicht auafweist.

6. Verfahren nach einem der vorstehenden Ansprüche, wobei es sich beim ersten oder zweiten Substrat um eine gedruckte Leiterplatte handelt, während es sich beim anderen Substrat um einen Halbleiterchip (5) handelt.

7. Verfahren nach Anspruch 6, wobei es sich beim Halbleiterchip (5) um einen von einem Halbleiterwafer geritzten blanken Chip handelt.

8. Verfahren nach Anspruch 7, wobei die Höcker (4) über der gesamten Oberfläche des Halbleiterwafers vor dem Ritzen ausgebildet werden.

## Revendications

1. Procédé pour former des bosses (4) de matériau conducteur électriquement sur des pastilles (2) formées sur une surface d'un premier substrat (1), lesdites bosses (4) étant destinées à l'interconnexion avec des pastilles correspondantes (6) formées sur un second substrat (5) en plaçant les bosses (4) sur les pastilles correspondantes (6) et en chauffant pour faire fondre les bosses (4), ledit procédé comprenant les étapes de :
a) orienter le premier substrat (1) de sorte que sa surface fait face vers le bas ;
b) déposer du matériau conducteur électriquement fondu de quantité contrôlée vers le haut sur la surface du premier substrat (1) qui fait face vers le bas pour former substantiellement des bosses (4) semi-sphériques sur la pastille (2), **caractérisé en ce que**
avant l'étape a) une étape c) de couvrir la surface du premier substrat (1) avec une résistance (3) sauf sur les zones de pastilles (2) est effectuée, et l'étape b) est réalisée en pulvérisant vers le haut ledit matériau conducteur électriquement fondu.

2. Procédé selon la revendication 1, dans lequel le matériau fondu conducteur électriquement est pulvérisé pendant que le premier substrat (1) est transmis.

3. Procédé selon la revendication 1 ou 2, dans lequel la quantité de pulvérisation de matériau conducteur électriquement fondu est ajustée pour former les bosses (4) de taille désirée.

4. Procédé selon la revendication 1, 2 ou 3, dans lequel deux ou plusieurs matériaux conducteurs électriquement fondus différents sont pulvérisés de sorte que chaque bosse (4) consiste en deux ou plusieurs couches de matériaux conducteurs électriquement différents.

5. Procédé selon la revendication 4, dans lequel lesdits deux ou plusieurs matériaux conducteurs électriquement fondus différents forment une couche supérieure (4a) de chaque bosse (4) sur les pastilles, la couche supérieure étant d'un matériau conducteur électriquement ayant un point de fusion inférieur à celui de la couche inférieure (4b) de chaque bosse (4) sur ladite couche supérieure.

6. Procédé selon l'une quelconque des revendications précédentes, dans lequel l'un ou l'autre du premier et second substrat est une carte de circuit imprimé alors que l'autre substrat est une puce (5) de semi-conducteur.

7. Procédé selon la revendication 6, dans lequel la puce de semi-conducteur (5) est une puce nue gravée depuis un disque de semi-conducteur.

8. Procédé selon la revendication 7, dans lequel les bosses (4) sont formées sur la surface entière du disque de semi-conducteur avant d'être gravées.
